# EUROPEAN PATENT APPLICATION

(11) **EP 0 736 901 A1**
(43) Date of publication of application: **09.10.1996**
(21) Application number: 96302356.9
(22) Date of filing: 03.04.1996
(51) Int. Cl.: H01L 23/544

(54) **Multiple colour marking of integrated circuit packages**

(30) Priority: 05.04.1995 US 417328
(71) Applicant: TEXAS INSTRUMENTS INCORPORATED, Dallas Texas 75265 (US)
(72) Inventor: Chou, Jack, Pao Chiao 220 (TW); Tsai, Lisa, Chung Ho, Taipei Hsien 235 (TW); Hsu, Mike, Taipei, 105 (TW)
(74) Representative: Whitlock, Holly Elizabeth Ann

(57) **Abstract**

A method and apparatus for providing a multiple color image pattern on an integrated circuit package. A transport means is provided to move carriers (63) which carry integrated circuit packages (61) with or without integrated circuits. An ink printing machine is used to apply a first color pattern through a first pattern symbol plate (73) onto the surface of said integrated circuit packages (63). An in line ink curing machine (77) is used to cure the ink pattern. A second color of ink is applied by a second ink printing machine onto said integrated circuit package. A second ink curing machine is then used to cure said second ink pattern. By repeating this ink color printing and curing cycle, using a separate pattern mask for each color, any desired pattern may be created on the integrated circuit package. The pattern may include trademarks, trade names, logos, advertising slogans, alphabetic and numeric characters, and machine readable patterns. Symbolization information, part numbers, and lot numbers may be included. Any number of colors may be used. Some colors may be used as backgrounds for other colored elements. Other embodiments are also described.

## Description

### FIELD OF THE INVENTION

This invention relates generally to the field of integrated circuits and the use of color image patterns for the ornamentation, symbolization and visual and machine readable identification for the packages of integrated circuits.

### BACKGROUND OF THE INVENTION

In producing integrated circuits, it is desirable to provide distinctive markings and patterns on the outer package of the completed integrated circuit. The information conveyed by such markings usually should include the type of circuit, the model number, and the manufacturer of the circuit, and other required information such as where the circuit is made. This marking should be permanent, easily read once the circuit is installed for easy verification, easily applied in a mass production environment, and inexpensive so as not to negatively impact the cost and competitiveness of the devices. It is also desirable to use trademarks, trade names and manufacturers logos on the integrated circuit to increase the consumer identification and source attribution properties of the image on the integrated circuit. Patterns and characters that indicate performance characteristics and special features may be used in order to increase the consumer demand for the part. The use of the pattern on the packaged part also ensures that the purchaser of the device and the systems built with the device can readily identify the maker of the integrated circuit, and can easily distinguish between makers by visually inspecting the integrated circuit. The purchaser and consumers should be able to specify which manufacturer's IC is desired in a given product or system, and the consumer should be able to readily verify that the devices used are in fact from the chosen manufacturer.

In the prior art, the marking on integrated circuits typically consists of simple lettering and numbering applied in a single typeface and color, usually white, using a laser symbolization machine, so that the pattern and markings are referred to as the package symbolization. While this technique is effective in meeting the productivity and cost requirements for IC symbolization, it fails to provide a distinctive mark that makes a particular IC manufacturers products easy to identify in an board or system. Further, the visual distinctiveness of the markings is low, so that it is hard to distinguish one vendors products from another. This can lead to a failure for the consumer or end user to ensure the integrated circuits used in a particular board or system are in fact purchased from a specified integrated circuit vendor. Also, it is difficult to use trademarks, logos, and trade names with these systems. Identifying a particular prior art IC as being manufactured by a certain maker is difficult because the prior art symbolization patterns used in the industry are virtually indistinguishable from one another. Once the IC is inserted into a board or system it becomes particularly difficult to identify.

Thus there is a need for an improved image patterning or symbolization scheme for use in producing integrated circuits and systems to provide enhanced identification of integrated circuits and to improve the identification of the trademarks and trade names of the manufacturer of the integrated circuit with the integrated circuits themselves.

### SUMMARY OF THE INVENTION

A multiple color IC package patterning or symbolization method and an apparatus for integrated circuit production with multiple color image patterns is described. A color printing machine is used for each one of several colors to be applied to the packaged integrated circuit. A conveyor belt or other automated transport system carries the integrated circuit packages from one color printing machine to the next. After the first color is applied, the integrated circuit packages are transported to a curing station where the first color ink is dried or cured. The integrated circuit packages are then transported to the next color printing machine where the next color is applied. This process of alternately printing and curing each color continues until all of the desired colors are applied. Inks are used which have a great adherence to the ceramic, metal or plastic surfaces of the particular integrated circuit packages. The curing process between printing stages ensures the inks will not smear or run together, so that the color pattern remains sharp and distinct. Any desired pattern or typeface may be achieved because each of the color printing machines has a customized printing pattern controlled by a symbol plate. These symbol plates are produced using laser symbol mask production technology and so any line, curve or shape may be defined of a variety of widths. A final curing step may be used to enhance the durability of the resulting symbolization. The resulting multicolor image pattern and symbolization can include the manufacturers logo or trademark, slogans, trademarks or slogans particular to the device being produced, or any other desired descriptive or decorative information, either for human visual reading or machine reading.

### BRIEF DESCRIPTION OF THE DRAWINGS

FIG. 1 depicts an example of the top surface of an integrated circuit having a multicolor symbolization pattern produced by the method of the invention;
FIG. 2 depicts the method of providing the multicolor patterns of the invention in a process flow diagram;
FIG. 3 depicts the physical steps required to implement the method of the invention;
FIG. 4 depicts in more detail some of the critical physical steps shown in FIG. 3; and
FIG. 5 depicts an example symbol plate used in the inking process as shown in FIGS. 3 and 4.

Corresponding numerals are used for corresponding elements in the drawings, unless otherwise indicated in the text.

### DETAILED DESCRIPTION OF PREFERRED EMBODIMENTS

To achieve multicolor patterning or symbolization for integrated circuits, it is necessary to provide an inexpensive, high throughput process which will result in a distinctive pattern and symbol that is durable and easy to read. The inks chosen must have adherence properties that are compatible with the plastic, metal or ceramic package being used in the process. Also, the inks must not run together or smear during the process. The resulting pattern or image must be permanent and not easily smudged, smeared or damaged during normal handling of the integrated circuit.

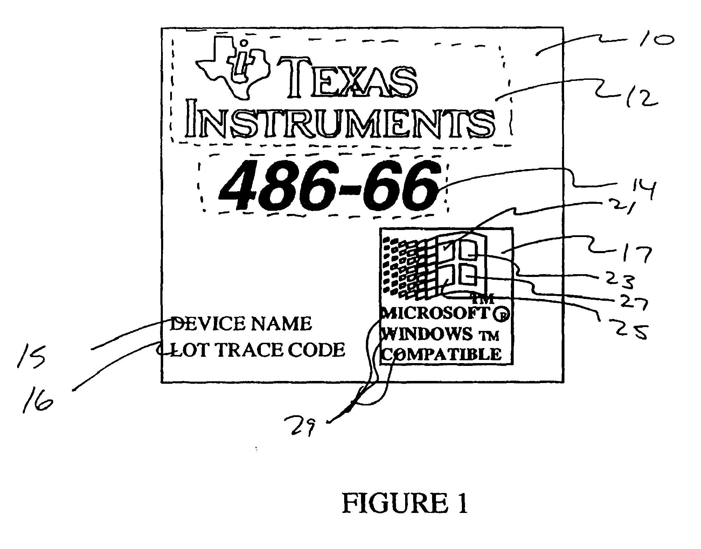

FIG. 1 depicts an exemplary integrated circuit with a multiple color symbol on the top surface of the package. In FIG. 1, IC 10 has pattern areas 12 and 17 which are produced in a white color, areas 14, 15 and 16 which are a black color, area 21 which is red, area 23 which is green, area 25 which is blue and area 27 which is a yellow color. Area 10 is the manufacturers logo which identifies the source of the particular IC. Area 12 is a device type and performance rating. Area 17 forms a white background for the trademark and feature information printed within area 17. In this example, area 17 is used to point out that this particular processor IC will operate correctly with another vendor's software, which is visually indicated by reproducing in accurate shape and color the vendors trademark, areas 21, 23, 25, 27, and by the accompanying text message in element 29. Text elements 15 and 16 provide additional manufacturing information to identify where and which lot the particular IC comes from. Although not used in this example, the pattern may include automatically read symbols such as UPC (Universal Product Code) fields or so called "bar" codes for automatic reading by machinery. Other machine readable patterns may also be used, if desired.

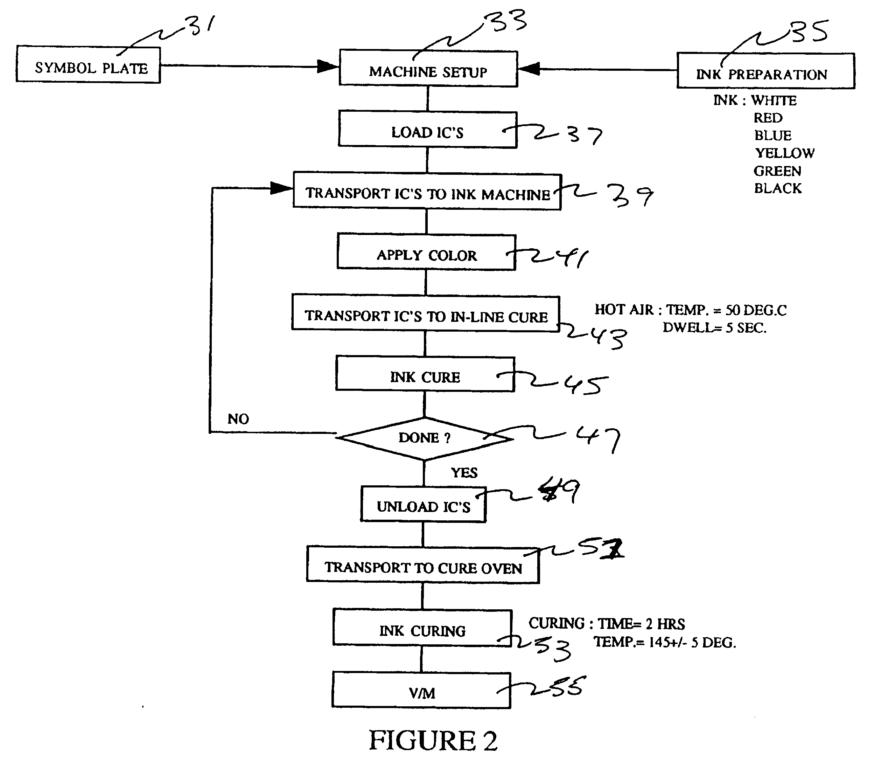

FIG. 2 is a process flow diagram describing the process used to produce integrated circuits having the multicolor symbolization.

In state 31 of FIG. 2, a symbol plate is provided for the particular color to be placed on the package. The symbol plate is loaded into the printing machine. The symbol plate will have approximately the same area as the target surface of the IC. Typically the plate will have recesses where the symbol is to be formed for a particular color. The recesses will retain ink.

In state 35, the particular color of ink is selected. The inks can be of any color. For the example of FIG. 1, the colors shown are provided.

In state 33, the printing machine receives the ink and symbol plate for the particular layer.

In state 37 of FIG. 2, the flow diagram represents the step of loading the integrated circuit packages into the carriers. This can be done manually or automatically. These carriers can be plastic, metal or made of any other durable material. Importantly, the carriers must be compatible with the symbolization machines and maintain a steady orientation of the IC as they are transported from one machine to the next. Different packages may require modification of the carrier, it should be arranged to receive the I.C. without contacting the pins of the device.

In state 39, the carriers are transported from the loading area to one of the symbolization or inking machines.

In state 41, a single color is applied. This can be done in a variety of ways and the particular method used is not critical, but typically involves inking the symbol plate, wiping away the excess ink, using a transport medium such as a roller or rubber ball to pick up the pattern from the symbol plate and then applying the roller or rubber ball to the packaged IC in the carrier. The roller will transfer the ink pattern from the symbol plate to the IC, the pattern appearing on the IC on the same place as it appeared on the symbol plate.

In state 43, the packages are now transported to one of the in-line curing machines.

In state 45, the in line cure is performed. This cure stage is done between colors of ink to stabilize the most recently applied color of ink, so that a subsequent ink layer can be applied without running or smearing, or merging of colors. This cure can be accomplished using any well known energy source such as light, heat, forced air, or heated air, as examples, however a simple and effective choice is a hot air stream of around 50 degrees Celsius applied to the surface for 5 seconds. Longer or shorter times can be used dependent on the type and brand of ink selected, and the type of package used for a particular IC.

In state 47, a test is made. If the final color has been applied, the devices are completely patterned or symbolized and leave the area. If not, the flow diagram shows a repeat of states 39, 41, 43, 45 and 47. The devices are transported to the next inking or color symbolization machine in state 39.

After the final ink layer is applied, the IC's are unloaded from the printing machine carriers and transported to a final cure oven in state 51.

State 53 is a final oven cure to make the multicolor symbol permanent. This cure can be accomplished in a variety of ways as well. Heat, light, Ultra-Violet, halogen or other energy sources may be used. An effective method is to cure the devices at 140-150 degrees Celsius for 1-3 hours. Humidity and ink type will again effect the type of cure selected.

After the final cure is performed, the pattern will be checked for accuracy, proper patterning, permanence, and the devices are complete. This validation step is shown in state 55 of FIG. 2.

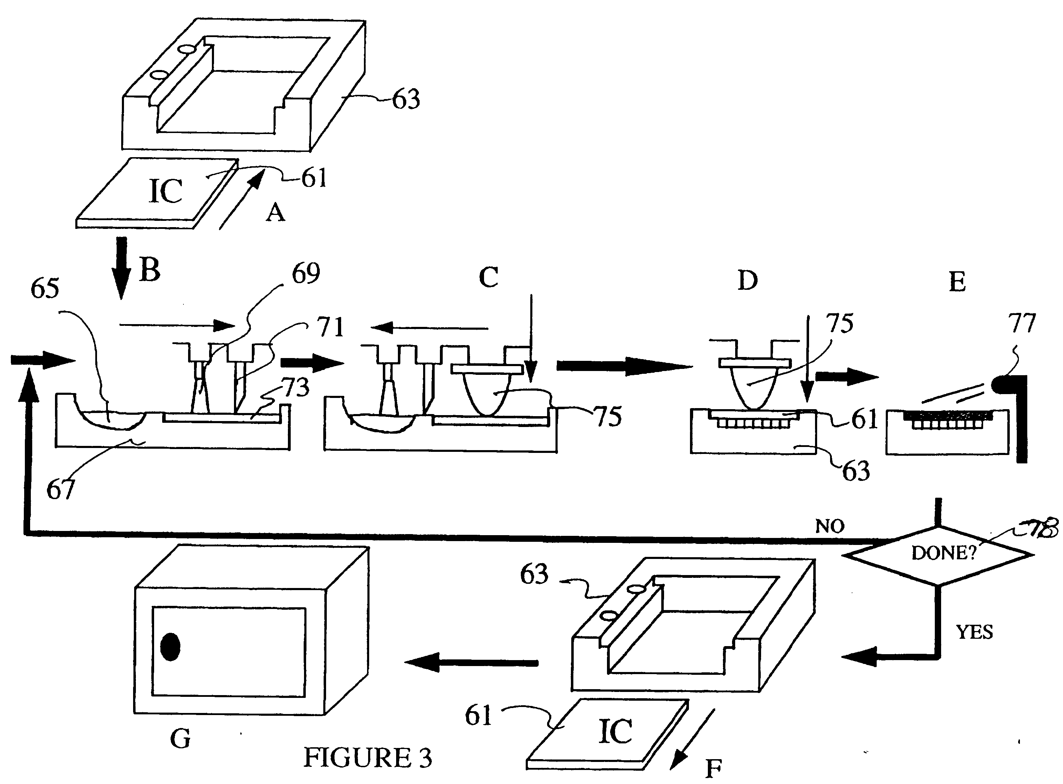

FIG. 3 depicts the physical steps and the typical apparatus used to implement the process of FIG. 2. In step A of FIG. 3, an IC 61 is loaded into carrier 63. The carriers 63 are designed to receive the IC and support it so that during the printing process the IC is held stationary and the carrier is machined to receive the pins of the IC without contacting the pins, that is the carrier has a beveled lip and a recess, where the recess is deeper than the longest pin of the IC and the lip catches the IC and holds it in a predetermined position. The carriers and ICs are then transported to the machine and await the ink.

Step B of FIG. 3 shows the basic operation of a typical multiple color printing machine. Each printing machine or symbolizer is a multicolor printing machine which is commonly available on the market for printing on objects such as golf balls, paper weights, plaques, etc. A typical example is model WE-166B Multi Color Fixture available from Guger Industries Co. Ltd., Taipei, Taiwan, R.O.C. This symbolizer is capable of printing multiple colors through symbol plate 73 onto the object. However, for integrated circuits, it is not feasible to wait between inks to print the next color. Also, rapid printing of multiple colors on an integrated circuit package at one station using conventional process steps results in smeared colors, loss of definition, and unacceptable results. The device throughput rate or productivity time is unacceptable as well. Also, the machine as sold is unable to process integrated circuit packages. A custom carrier 63 has been developed to transport the integrated circuit packages into and out of the print area of the machines.

The selected ink is placed in an ink reservoir 65 in the machine which is placed adjacent the selected symbol plate 73, which is held in receptacle 67. In step B the ink from the reservoir is placed on the symbol mask by the operation of blade 71 and brush 69.

Step C of FIG. 3 shows the transfer of the ink symbol to the rubber tip 75. The symbol plate has recesses in it which now contain the ink, the rest of the plate having been wiped clear by the action of blade 71 in step B. As the rubber tip is dragged across the symbol plate the pattern will be transferred onto it. Note that in step C the brush 69 is also moved into the reservoir, where it receives ink for the next printing pass.

The rubber tip used in the embodiment describe here picks up the ink pattern by being mechanically pressed down on the symbol plate. Solvents or thinners are used with the ink to achieve the correct viscosity so that the ink is picked up and transferred onto the rubber tip correctly. These thinners or solvents are well known to those in the art.

Step D shows the transference of the ink from the rubber tip to the surface of the IC itself. The symbol plate and the IC surface to be printed should be of approximately the same size, so that if the rubber tip is moved the onto the IC in the same manner as it was moved onto the symbol plate in Step C, the inked pattern will appear on the IC in a respective size and place as it appears on the symbol plate initially.

Step E shows the carrier and IC at the in line curing stage. Blower 77 now applies hot air to the surface of the IC and cures the ink. This in line cure is a short cure used only to make sure the colors do not run together, smear or otherwise interfere with each other. For a typical environment, the in line cure can be, for example, 50 degrees Celsius forced air applied to the surface of the IC for 5 seconds. A longer final cure is used after the last ink layer is applied. Although blower 77 is shown, curing may also use only heat, only forced air, light, or other known and available means to provide the cure for the ink. A low temperature oven could be used, however in order to provide the desired fast throughput forced, heated air provides good results. If the throughput rate is slower, for instance if cool air is used, additional production lines would be required to reach the desired level of device per hour throughput, which would require additional capital expense. Also, space and equipment operation and maintenance requirements would increase.

After the in line cure of Step E is complete, there is a decision step shown, element 78, which tests whether the device is completely patterned. Assuming it is not, the IC and carrier are transported to another printing step B and the next color is printed in the same manner as described above. Each color is printed and the in line cure is performed after each color. The use of the iterative printing and curing steps advantageously enables the printing of any number of colors on an IC without any loss of resolution. Complicated patterns and fine lines can be printed clearly and easily. Since the first ink pattern is already dry, no smearing or edge definition loss occurs if the second color meets or overlays the first color. Any pattern may be used and any colored patterned combinations may be fabricated without loss of definition or smearing defects because the inks are dried between printing steps.

The line may include, preferably, a separate inking machine and in line curing station for each color used in a particular pattern. Alternatively, a run of one color may be made on a plurality of devices, followed by a change of ink color and symbol plate, then the devices may be returned to the same inking machine and in line curing station, and so on until each of the plurality of devices has a completed pattern formed on it. A run of new devices can then begin by setting up the machine for the first pattern and ink color.

In more complex patterns, one color may be printed over another or within a region left blank in a previous step without blurring, smearing or loss of resolution and contrast. For example, in the region numbered 17 in FIG. 1, there is a white background formed. Regions 19, 21, 23 are then printed over the background to complete the pattern. Alternatives include replacing the first ink step with a matte finish over all or part of the IC, and then printing subsequent colors on the matte background.

After the completion of the color pattern or symbolization, the devices 61 are removed from the carriers 63 in step F. The carriers are returned to the front of the line to receive new packages in step A. The carriers 63 may need to be cleaned periodically to prevent color from getting on the leads and underside of the packages of the IC's. Preferably, a mechanism, not shown, is provided to automatically load and unload the integrated circuits from the carriers so that no human intervention is required. This mechanism may comprise, as an example, a robot arm with a vacuum chuck for lifting the IC package, inserting it into the carrier, and releasing it; then reversing the operation after symbolization or color pattern imaging process is completed.

After the devices 61 are unloaded from the carrier, they are transported to the oven G where the final cure is performed. A cure of two hours at 135-160 degrees Celsius has been found to be effective. Alternatives can be used instead of the oven shown in step G. For example, U/V or halogen light, air dry, or other curing methods can be used. The key requirement is that the pattern meet the permanence standards of the I.C. industry. The device shown in FIG. 1 has been qualified by passing industry standardized tests for symbol permanence. A permanent symbol will not be smeared or damaged in normal handling, nor will it fade or wash away.

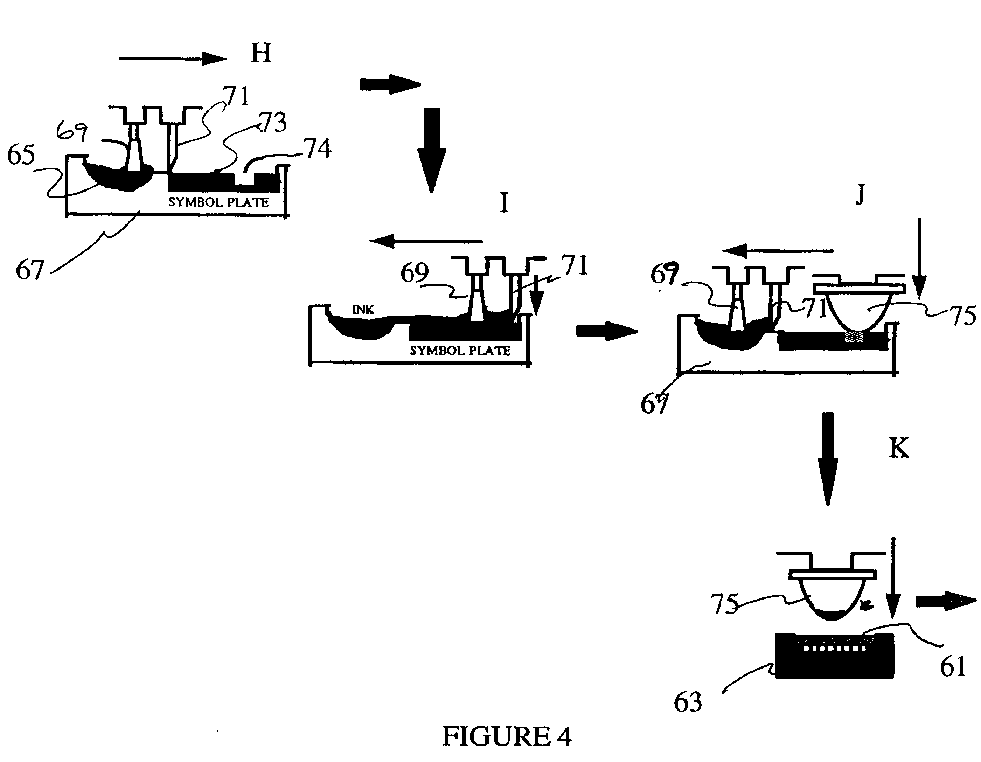

FIG. 4 depicts more detail of the steps depicted in FIG. 3. In step H, brush 69 picks up ink from the reservoir 65 and sweeps it onto the symbol plate 73. Blade 71 is a sharp blade which will prevent ink from flowing past the blade, so the ink must stay between the blade edge and the reservoir 65. The symbol plate 73 rests in a notched plate holder 67 so that the top surface of the plate is flush with the top of the holder. Pattern 74 is made into the plate and having a depth of 0.5-1.0 mils.

In step I of FIG. 4, the symbol plate is swept clean of excess ink. The brush 69 returns to the reservoir 65 where ink is picked up for the next pass. The blade 69 will sweep the excess ink back into the reservoir. The symbol will have ink filling the recesses, and the rest of the mask will be free of ink.

Step J shows the transference of the pattern from the symbol mask to the rubber tip 75. This is done by taking advantage of the viscosity characteristics of the ink. The viscosity may be controlled through the use of commercial thinners and solvents as is well known in the art. The rubber tip is pressed downward onto the symbol plate and picks up the ink pattern from the plate.

Step K shows the transference of the pattern to the IC surface. The I.C. package may be plastic, ceramic, alumina, or metal. Differing inks may be experimented with to find the best ink for a particular type of package as is conventionally done in the art. The rubber tip 75 is pressed downward to transfer the ink onto the surface. The IC and the symbol plate will typically be similar in area and aspect ratio, so that the pattern of the symbol plate will appear in the same size and place on the surface of the IC. Typically the inked pattern will be of similar depth to the depth of the pattern on the plate, e.g.0.5-1.0 mils thick. Thicker patterns are easily made by using deeper recesses on the plate 73.

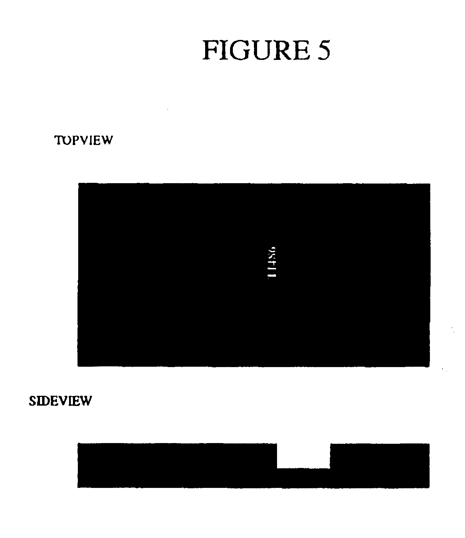

FIG. 5 depicts an example symbol plate for a single color in an example pattern. The top view shows the pattern so it is easily visible. The side view is a cut away view through the pattern and shows the recess in the symbol plate.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. A method for providing a image pattern on the surface of a package for an integrated circuit having at least two different colors of ink applied to the package, comprising the steps of:
applying a first ink pattern to said integrated circuit package;
curing said first ink pattern on said integrated circuit package;
applying a second ink pattern to said integrated circuit package;
curing said second ink pattern on said integrated circuit package; and
continuing to alternately apply an ink pattern and to cure said ink pattern until said image pattern is completed.

2. The method of Claim 1, wherein said steps of applying said first ink pattern and said second ink pattern to said integrated circuit package each further comprise:
providing a ink printing machine with a single color of ink supplied to it;
providing a pattern mask to use with said ink printing machine, the pattern mask defining the elements of said image pattern that are of said single color of ink; and
forming the pattern specified by said pattern mask on said integrated circuit package in said single color of ink.

3. The method of Claim 1 or Claim 2, wherein said steps of curing said first ink pattern and said second ink pattern each further comprise the steps of:
providing a source of heat over said integrated circuit package;
providing a source of air coupled to said source of heat; and
applying a stream of heated air to said ink pattern on said integrated circuit package until said ink pattern is cured.

4. The method of Claim 1 or Claim 2, wherein said steps of curing said first ink pattern and said second ink pattern each further comprise the steps of:
providing a source of heat over said integrated circuit package; and
applying heat to said integrated circuit until said ink pattern is cured.

5. The method of Claim 1 or Claim 2, wherein said steps of curing said first ink pattern and said second ink pattern each further comprise the steps of:
providing a source of light over said integrated circuit package; and
applying light to said integrated circuit until said ink pattern is cured.

6. The method of Claim 5 wherein said source of light provides ultra-violet light.

7. The method of Claim 5 wherein said source of light provide light from a halogen light source.

8. The method of any preceding claim wherein said method of providing an image pattern on the package of an integrated circuit further comprises the steps of:
curing said completed image pattern until it becomes permanently affixed to said integrated circuit.

9. The method of any preceding claim further comprising:
providing a transport mechanism for transporting integrated circuit packages;
providing a plurality of color patterning machines adjacent said transport mechanism, each of said color patterning machines having a symbol mask for printing a single ink symbol on integrated circuit packages as they move on said transport mechanism, and each of said color patterning machines being provided with a supply of single color of ink;
providing a plurality of curing machines adjacent said transport mechanism, one of said plurality of said curing machines being associated with and located after each of said color patterning machines, each of said curing machines for curing said ink symbol on said integrated circuit packages as they move on said transport mechanism; and
placing said color patterning machines and said curing machines such that as the integrated circuit packages move on said transport mechanism they receive an ink symbol for each of a plurality of colors, then said ink symbol is cured, then they receive a subsequent ink symbol from the remainder of said plurality of colors, and said subsequent ink symbol is cured, these ink symbol and curing steps being repeated until the plurality of colors is exhausted, thereby forming a multicolor image pattern on said integrated circuit package using each of said plurality of colors.

10. The method of claim 9, wherein said step of providing a transport mechanism further comprises the steps of:
providing a carrier having an inner surface shaped to receive an integrated circuit package, and having an outer surface shaped to fit into an orifice in said patterning machines, such that said carrier is received by said patterning machine and said integrated circuit package is maintained in a fixed position while said ink symbols are printed on said integrated circuit package; and
providing a means for moving said carriers and said integrated circuit packages from each one of said patterning machines to an associated one of said curing machines and then to a subsequent one of said patterning machines.

11. The method of Claim 9 or Claim 10, wherein said step of providing a plurality of patterning machines further comprises the step of:
providing an ink patterning machine and a patterned mask for each one of a plurality of colors used in the image pattern, such that all of the elements of a particular color in said image pattern are created with a single inking step.

12. The method of Claim 11, wherein said step of providing an ink patterning machine and a patterned mask further comprises providing a patterned mask having a pattern formed using a laser mask patterning machine.

13. The method of Claims 9 to 12, wherein said step of providing a plurality of colors comprises the step of providing an ink color of each of said plurality of colors, wherein each of said ink colors comprises ink containing a solvent.

14. The method of Claims 9 to 13 wherein said step of providing a plurality of curing machines comprises the step of providing a plurality of machines which direct heated air onto the surface of said integrated circuits to cure said ink patterns.

15. The method of Claims 9 to 13 wherein said step of providing a plurality of curing machines comprises the step of providing a plurality of machines which direct heat onto the surface of said integrated circuits to cure said ink patterns.

16. The method of Claims 9 to 13 wherein said step of providing a plurality of curing machines comprises the step of providing a plurality of machines which direct light onto the surface of said integrated circuits to cure said ink patterns.

17. An integrated circuit package having a multiple color image pattern on one surface, said image pattern comprising at least two colors in addition to the color of the integrated circuit package.

18. The integrated circuit package of Claim 17, wherein one of said at least two colors lies underneath one or more of the remaining at least two colors.

19. The integrated circuit of Claim 18, wherein said one of said at least two colors which lies underneath one or more of the remaining at least two colors covers substantially all of said one surface of said integrated circuit package.

20. An integrated circuit package having a multiple color image pattern on one surface, wherein said multiple color image pattern is formed using a process which comprises the steps of:
applying a first ink pattern to said integrated circuit package;
curing said first ink pattern on said integrated circuit package;
applying a second ink pattern to said integrated circuit package;
curing said second ink pattern on said integrated circuit package; and
continuing to alternately apply an ink pattern and to cure said ink pattern until said image pattern is completed.
